# EUROPEAN PATENT SPECIFICATION

(11) **EP 1 528 432 B1**
(45) Date of publication and mention of the grant of the patent: **10.03.2010**
(21) Application number: 04256584.6
(22) Date of filing: 26.10.2004
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 28.10.2003 EP 03256809
(43) Date of publication of application: 04.05.2005
(73) Proprietor: ASML Netherlands B.V., 5504 DR Veldhoven (NL); Carl Zeiss SMT AG, 73447 Oberkochen (DE)
(72) Inventor: Hoogendam, Christiaan Alexander, 5509 NC Veldhoven (NL); Loopstra, Erik Roelof, 5591 BA Heeze (NL); Streefkerk, Bob, 5038 PE Tilburg (NL); Gellrich, Bernard, 73434 Aalen (DE); Wurmbrand, Andreas, 73434 Aalen-Reichenbach (DE)
(74) Representative: Weenink, Willem

(56) References cited:
- EP-A- 1 420 298
- WO-A-99/49504
- WO-A-03/077034
- WO-A-2004/055803
- PATENT ABSTRACTS OF JAPAN vol. 1999, no. 03, 31 March 1999 (1999-03-31) -& JP 10 340846 A (NIKON CORP), 22 December 1998 (1998-12-22)

## Description

The present invention relates to a lithographic apparatus.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

It has been proposed to immerse the substrate in the lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.)

However, submersing the substrate or substrate and substrate table in a bath of liquid (see for example US 4,509,852)means that there is a large body of liquid that must be accelerated during a scanning exposure. This requires additional or more powerful motors and turbulence in the liquid may lead to undesirable and unpredictable effects.

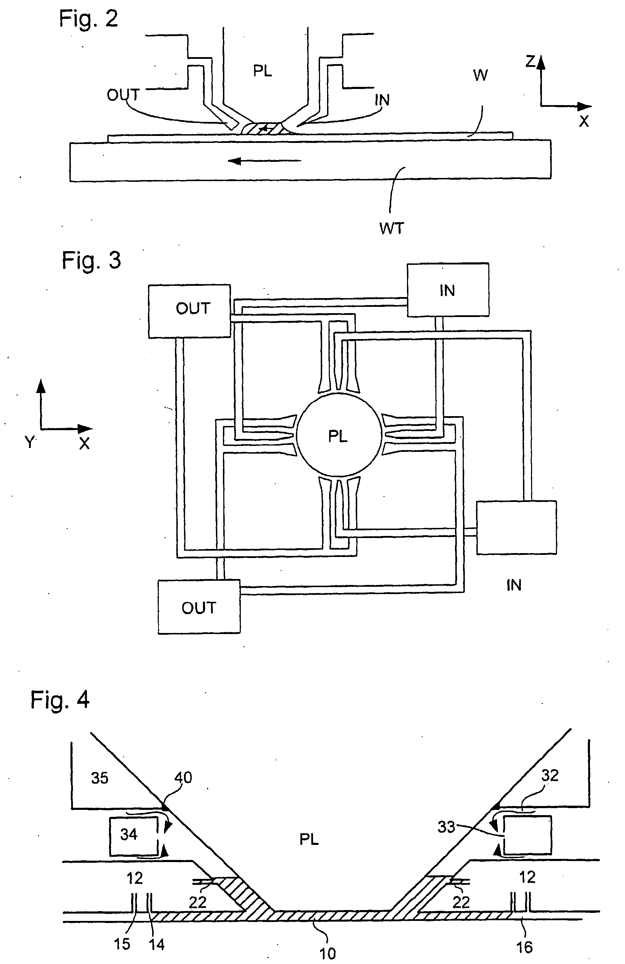

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a -X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

Another solution which has been proposed is to provide the liquid supply system with a seal member which extends along at least a part of a boundary of the space between the final element of the projection system and the substrate table. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal. Such as system is disclosed in European Patent Application No. 03252955.4.

The presence of liquid in the apparatus results in the surrounding air becoming very humid. Humidity levels of up to 100% have been recorded. Moisture in the air can enter other parts of the apparatus thus contaminating other machine parts and measurement components so the operation and accurate measurement of the apparatus becomes compromised. The moisture in the air can cause rusting of machine parts and therefore reduce the life span of the apparatus. To prevent the moisture-laden air from pervading the entire apparatus metal membranes are used to confine the humid air between the projection system and the seal member as relative movement. Alternatively, rubber-like viton rings can be used to confine the liquid. However, both these methods can result in the transmission of vibration forces between the projection system and the seal member.

WO 2004/055803 and EP 1 420 298, which belong to the prior art according to Article 54(3) EPC, disclose a lithographic apparatus in which an immersion liquid fills a space between the final element of the projection system and the substrate and a gas seal which provides a gas flow used to confine the immersion liquid extends along the boundary of said space.

It is an object of the present invention to provide a method of confining humid air.

According to an aspect of the invention, there is provided a lithographic apparatus according to claim 1.

The humid air above (where down is the direction of propagation of the projection beam) the liquid is thus confined to a small volume relative to the projection apparatus and there is no rigid connection between parts of the apparatus so relative movement between parts of the apparatus can occur freely. The gas used should be clean and dry to avoid damage to the apparatus and to absorb the humidity.

The gas flow means is preferably comprises a vacuum source, which may also remove contaminants from the system. The contaminants removed can be solid particles (which could damage the apparatus by scratching it), liquid particles or gaseous particles other than the gas itself. The vacuum source may comprise a vacuum chamber with an annular inlet, the projection system being arranged at the center of said annulus.

The gas flow means comprises a passage through which said flow of gas flows. The passage therefore bounds the volume of humid gas and the clean, dry gas flowing through the passage prevents the humid gas from escaping. The passage may be formed at least partly by part of the projection system and the gas flow means.

The projection system may further comprise a lens cover, the lens cover forming said part of said passage, said lens cover being joined to the rest of the projection system by a lens seal. The lens cover thus provides an airtight cover to the projection system, preventing humid air from entering the projection system. The lens seal should be flexible and is preferably a glue. Relative movement between parts of the apparatus is therefore not compromised.

The liquid supply system comprises a seal member extending along at least part of the boundary of said space between the final element of said projection system and said substrate table wherein said gas flow means is arranged so that said flow of gas is between said seal member and said projection system. Due to the presence of the gas flow means relative movement between the seal member and the projection system can take place. The apparatus is preferably arranged so that the gas flow means is arranged between the projection system and said seal member. The seal member optionally comprises a gas seal means for forming a gas seal between said seal member and the surface of said substrate. The humid air is therefore confined by the substrate, gas seal means, the seal member, the gas flow means and the projection system. The seal member is mounted onto the base frame of the lithographic projection apparatus. The seal member is preferably movable relative to the base frame in the Z, Rx and Ry directions (where the Z direction is the direction of propagation of the projection beam) but fixed in all other directions.

According to a further aspect of the invention, there is provided a device manufacturing method according to claim 14.

The invention could easily be used with the liquid supply system illustrated in Figs 2 and 3. Additional inlets and outlets arranged in the space above the immersion liquid would generate a gas flow which would absorb the immersion fluid from the gaseous space above the immersion liquid.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm).

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Embodiments of the invention will now be described, by way of example only, with reference to the accompanying schematic drawings in which corresponding reference symbols indicate corresponding parts, and in which:
Figure 1 depicts a lithographic apparatus to be used with the invention;
Figure 2 depicts a liquid supply system to be used with the invention;
Figure 3 is an alternative view of the liquid supply system of Figure 2; and
Figure 4 is a detail of a lithographic projection apparatus according to an embodiment of the invention.

### EMBODIMENTS

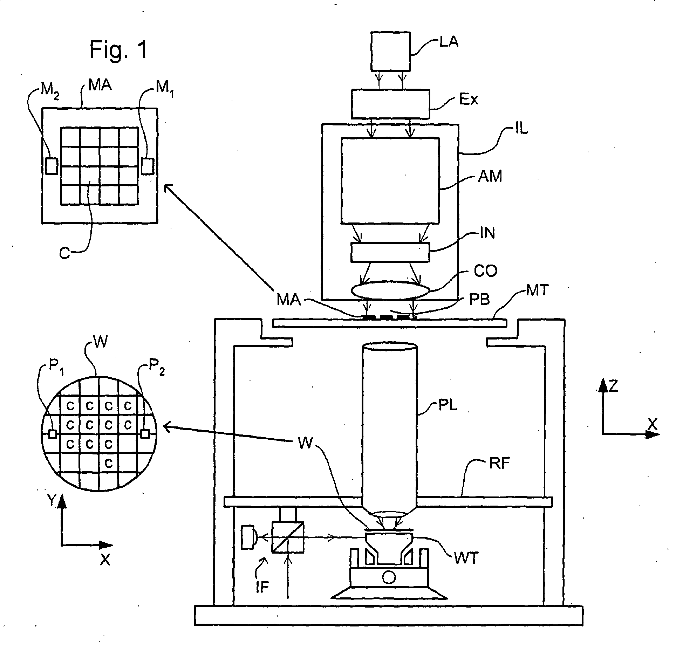

Figure 1 schematically depicts a lithographic apparatus. The apparatus comprises:
- an illumination system (illuminator) IL for providing a projection beam PB of radiation (e.g. UV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular-intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

As shown in Figure 4 a liquid reservoir 10 between the projection lens and the substrate is bounded by a gas seal 16 forming an annulus around the projection lens. The gas seal 16 is formed by gas e.g. air or synthetic air but preferably N₂ or another inert gas, provided under pressure via inlet 15 to the gap between seal member 12 and substrate and extracted via first outlet 14. The over pressure on the gas inlet 15, vacuum level on the first outlet 14 and geometry of the gap are arranged so that there is a high velocity air flow inwards that confines the liquid. The distance between the gas inlet and outlet and substrate W is small.

The liquid reservoir is supplied with liquid by inlet 22 and extends above the bottom of the final element of the projection system PL. Excess liquid is removed via outlet 14.

As shown in Figure 4 the projection system also comprises a lens cover 35 attached to the main part of the projection system PL by a seal 40. The seal 40 should be flexible to accommodate small relative movement between the main part of the projection system PL and the lens cover 35. Glues have been found to be particularly effective.

A vacuum chamber 34 with an inlet 33 is arranged in the volume above the reservoir 10. The outside of the vacuum chamber 34 and lens cover 35 form a passage 32 along which gas flows towards vaccum chamber 34. In addition to the gas flowing along passage 32 gas from all surrounding areas will flow towards the vacuum chamber 34. The partial vapour pressure of the immersion fluid in the gas above the reservoir 10 is high, and the flow of gas along passage 32 prevents the humid gas from entering the projection system PL. Additionally the gas flow will absorb humidity from surrounding gas so there is a gradient of humidity, the humidity of the gas decreasing away from the reservoir 10. Thus delicate parts of the apparatus such as mirrors for the interferometer beams are arranged in a dry part of the apparatus so humidity doesn't affect the measurements. Additionally, if glue is used as seal 40 the dry, flowing gas will ensure that the glue remains dry and therefore an airtight seal is maintained. Keeping the glue 40 dry also prevents it from expanding and thus generating forces which may deform the projection system.

The vacuum chamber 34 can be independent of the projection system as in the example above, or can be part of the projection system PL, or part of the seal member 12 and in any of these circumstances may be actuatable in the z direction. There may be a plurality of gas passages 32 and vacumm chambers 34 can be arranged around the projection system PL, or alternatively one annular shaped vacuum chamber with a slit inlet. Although the example here is of a vacuum chamber i.e. an underpressure generating a gas flow, the gas flow means could equally comprise an overpressure.

A system as described above could also be used in conjunction with the liquid supply system shown in Figures 2 and 3, the vacuum chamber 34 and passage 32 being arranged above the inlets IN and outlets OUT.

While specific embodiments of the invention have been described above, it will be appreciated that the invention may be practiced otherwise than as described. The description is not intended to limit the invention which is defined by the claims.

## Claims

1. A lithographic apparatus comprising:
- an illumination system (IL) for providing a projection beam (PB) of radiation;
- a support structure (MT) for supporting patterning means (MA), the patterning means serving to impart the projection beam (PB) with a pattern in its cross-section;
- a substrate table (WT) for holding a substrate (W);
- a projection system (PL) for projecting the patterned beam (PB) onto a target portion of the substrate (W);
- a liquid supply system arranged to at least partly fill a space between the final element of said projection system (PL) and said substrate (W) with immersion liquid; and
- a seal member (12) extending along at least a part of the boundary of said space;
wherein the apparatus further comprises a gas flow means (34) arranged to provide a flow of gas towards said immersion liquid and arranged to prevent the gas above and in contact with said immersion liquid from escaping beyond said gas flow means, wherein said gas flow means is arranged so that said flow of gas is between said seal member (12) and said projection system (PL).

2. A lithographic apparatus according to claim 1 wherein said gas flow means comprises a vacuum source.

3. A lithographic apparatus according to claim 2 wherein said vacuum is arranged to remove said gas in contact with said immersion liquid.

4. A lithographic apparatus according to either claims 2 or claim 3 wherein said vacuum is also arranged to remove contaminants from said gas in contact with said immersion liquid.

5. A lithographic apparatus according to any one of claims 2 to 4 wherein said vacuum source comprises a vacuum chamber (34) having an annular inlet, said projection system (PL) being arranged at the center of said annulus.

6. A lithographic apparatus according to any one of the preceding claims wherein said gas flow means comprises a passage (32) through which said flow of gas flows.

7. A lithographic apparatus according to claim 6 wherein said passage (32) is formed at least partly by said projection system (PL) and said gas flow means.

8. A lithographic apparatus according to claim 7 wherein said projection system (PL) further comprises a lens cover (35), the lens cover forming said part of said passage (32), said lens cover being joined to the rest of the projection system by a lens seal (40).

9. A lithographic apparatus according to claim 8, wherein said lens seal (40) is flexible.

10. A lithographic apparatus according to either claim 8 or claim 9, wherein said lens seal (40) is glue.

11. A lithographic apparatus according to claim 1 , wherein said seal member (12) further comprises a gas seal means for forming a gas seal (16) between said seal member (12) and the surface of said substrate (W).

12. A lithographic apparatus according to claim 11, wherein said seal member (12) is mounted onto a base frame.

13. A lithographic apparatus according to claim 12, wherein said seal member (12) is movable relative to said base frame in the Z, Rx and Ry directions and fixed in all other directions.

14. A device manufacturing method comprising:
- providing a substrate (W);
- providing a projection beam (PB) of radiation using an illumination system (IL);
- using patterning means (MA) to impart the projection beam with a pattern in its cross-section;
- providing a liquid between a final element of a projection system (PL) used in said step of projecting and said substrate (W) by at least partially filling a space between the final element and the substrate with immersion liquid;
- providing a seal member (12) extending along at least a part of the boundary of said space; and
- projecting the patterned beam of radiation onto a target portion of the substrate (W),
- providing a flow of gas from a gas flow means to flow in the space above said immersion liquid towards the immersion liquid for preventing the gas above and in contact with said immersion liquid from escaping beyond said gas flow means, wherein said gas flow means is arranged so that said flow of gas is between said seal member (12) and said projection system (PL).

## Patentansprüche

1. Ein lithographisches Gerät, das Folgendes beinhaltet:
- ein Beleuchtungssystem (IL) zum Bereitstellen eines Projektionsstrahls (PB) aus Strahlung;
- eine Stützstruktur (MT) zum Stützen von Musteraufbringungsmitteln (MA), wobei die Musteraufbringungsmittel dazu dienen, den Projektionsstrahl (PB) in seinem Querschnitt mit einem Muster zu versehen;
- einen Substrattisch (WT) zum Halten eines Substrats (W);
- ein Projektionssystem (PL) zum Projizieren des gemusterten Strahls (PB) auf einen Zielabschnitt des Substrats (W),
- ein Flüssigkeitszufuhrsystem, das eingerichtet ist, um einen Raum zwischen dem letzten Element des Projektionssystems (PL) und dem Substrat (W) mindestens teilweise mit Immersionsflüssigkeit zu füllen; und
- ein Dichtungsglied (12), das sich entlang mindestens eines Teils der Grenze des Raums erstreckt;
wobei das Gerät ferner ein Gasflussmittel (34) beinhaltet, das eingerichtet ist, um einen Fluss von Gas in Richtung der Immersionsflüssigkeit bereitzustellen, und das eingerichtet ist, um das Gas über und in Kontakt mit der Immersionsflüssigkeit davon abzuhalten, über das Gasflussmittel hinaus zu entweichen, wobei das Gasflussmittel so eingerichtet ist, dass sich der Fluss von Gas zwischen dem Dichtungsglied (12) und dem Projektionssystem (PL) befindet.

2. Lithographisches Gerät gemäß Anspruch 1, wobei das Gasflussmittel eine Vakuumquelle beinhaltet.

3. Lithographisches Gerät gemäß Anspruch 2, wobei das Vakuum eingerichtet ist, um das mit der Immersionsflüssigkeit in Kontakt befindliche Gas zu entfernen.

4. Lithographisches Gerät gemäß Anspruch 2 oder Anspruch 3, wobei das Vakuum auch eingerichtet ist, um Verunreinigungen aus dem mit der Immersionsflüssigkeit in Kontakt befindlichen Gas zu entfernen.

5. Lithographisches Gerät gemäß einem der Ansprüche 2 bis 4, wobei die Vakuumquelle eine Vakuumkammer (34) mit einem ringförmigen Einlass beinhaltet, wobei das Projektionssystem (PL) in der Mitte des Rings eingerichtet ist.

6. Lithographisches Gerät gemäß einem der vorhergehenden Ansprüche, wobei das Gasflussmittel einen Durchgang (32) beinhaltet, durch den der Fluss von Gas fließt.

7. Lithographisches Gerät gemäß Anspruch 6, wobei der Durchgang (32) mindestens teilweise von dem Projektionssystem (PL) und dem Gasflussmittel gebildet ist.

8. Lithographisches Gerät gemäß Anspruch 7, wobei das Projektionssystem (PL) ferner eine Linsenabdeckung (35) beinhaltet, wobei die Linsenabdeckung den Teil des Durchgangs (32) bildet, wobei die Linsenabdeckung durch eine Linsendichtung (40) mit dem Rest des Projektionssystems verbunden ist.

9. Lithographisches Gerät gemäß Anspruch 8, wobei die Linsendichtung (40) flexibel ist.

10. Lithographisches Gerät gemäß Anspruch 8 oder Anspruch 9, wobei die Linsendichtung (40) Klebstoff ist.

11. Lithographisches Gerät gemäß Anspruch 1, wobei das Dichtungsglied (12) ferner ein Gasdichtungsmittel zum Bilden einer Gasdichtung (16) zwischen dem Dichtungsglied (12) und der Oberfläche des Substrats (W) beinhaltet.

12. Lithographisches Gerät gemäß Anspruch 11, wobei das Dichtungsglied (12) auf einem Grundrahmen montiert ist.

13. Lithographisches Gerät gemäß Anspruch 12, wobei das Dichtungsglied (12) relativ zu dem Grundrahmen in den Richtungen Z, Rx und Ry beweglich und in allen anderen Richtungen ortsfest ist.

14. Ein Verfahren zur Herstellung einer Vorrichtung, das Folgendes beinhaltet:
- Bereitstellen eines Substrats (W);
- Bereitstellen eines Projektionsstrahls (PB) aus Strahlung unter Verwendung eines Beleuchtungssystems (IL);
- Verwenden von Musteraufbringungsmitteln (MA), um den Projektionsstrahl in seinem Querschnitt mit einem Muster zu versehen;
- Bereitstellen einer Flüssigkeit zwischen einem letzten Element eines Projektionssystems (PL), das in dem Schritt des Projizierens verwendet wird, und dem Substrat (W), indem ein Raum zwischen dem letzten Element und dem Substrat mindestens teilweise mit Immersionsflüssigkeit gefüllt wird;
- Bereitstellen eines Dichtungsglieds (12), das sich entlang mindestens eines Teils der Grenze des Raums erstreckt; und
- Projizieren des gemusterten Strahls aus Strahlung auf einen Zielabschnitt des Substrats (W),
- Bereitstellen eines Flusses von Gas aus einem Gasflussmittel, um in dem Raum über der Immersionsflüssigkeit in Richtung der Immersionsflüssigkeit zu fließen, um das Gas über und in Kontakt mit der Immersionsflüssigkeit davon abzuhalten, über das Gasflussmittel hinaus zu entweichen, wobei das Gasflussmittel so eingerichtet ist, dass sich der Fluss von Gas zwischen dem Dichtungsglied (12) und dem Projektionssystem (PL) befindet.

## Revendications

1. Un appareil lithographique comprenant :
- un système d'illumination (IL) destiné à fournir un faisceau de projection (PB) de rayonnement ;
- une structure formant support (MT) destinée à servir de support à un moyen pour conformer selon un motif (MA), le moyen pour conformer selon un motif servant à conférer au faisceau de projection (PB) un motif dans sa coupe transversale ;
- une table porte-substrat (WT) destinée à porter un substrat (W) ;
- un système de projection (PL) destiné à projeter le faisceau à motif (PB) sur une portion cible du substrat (W) ;
- un système d'alimentation en liquide arrangé pour remplir au moins en partie un espace entre l'élément final dudit système de projection (PL) et ledit substrat (W) de liquide d'immersion ; et
- un élément d'étanchéité (12) s'étendant le long d'au moins une partie du pourtour dudit espace ;
où l'appareil comprend de plus un moyen servant à l'écoulement de gaz (34) arrangé pour fournir un écoulement de gaz en direction dudit liquide d'immersion et arrangé pour empêcher le gaz au dessus de et en contact avec ledit liquide d'immersion de s'échapper au-delà dudit moyen servant à l'écoulement de gaz, où ledit moyen servant à l'écoulement de gaz est arrangé de sorte que ledit écoulement de gaz soit entre ledit élément d'étanchéité (12) et ledit système de projection (PL).

2. Un appareil lithographique selon la revendication 1 où ledit moyen servant à l'écoulement de gaz comprend une source de vide.

3. Un appareil lithographique selon la revendication 2 où ledit vide est arrangé pour retirer ledit gaz en contact avec ledit liquide d'immersion.

4. Un appareil lithographique selon soit la revendication 2, soit la revendication 3 où ledit vide est aussi arrangé pour retirer des contaminants dudit gaz en contact avec ledit liquide d'immersion.

5. Un appareil lithographique selon une quelconque des revendications 2 à 4 où ladite source de vide comprend une chambre à vide (34) présentant un orifice d'entrée annulaire, ledit système de projection (PL) étant arrangé au centre dudit anneau.

6. Un appareil lithographique selon une quelconque des revendications précédentes où ledit moyen servant à l'écoulement de gaz comprend un passage (32) dans lequel ledit écoulement de gaz s'écoule.

7. Un appareil lithographique selon la revendication 6 où ledit passage (32) est formé au moins en partie par ledit système de projection (PL) et ledit moyen servant à l'écoulement de gaz.

8. Un appareil lithographique selon la revendication 7 où ledit système de projection (PL) comprend de plus un couvercle de lentille (35), le couvercle de lentille formant ladite partie dudit passage (32), ledit couvercle de lentille étant joint au reste du système de projection par un joint de lentille (40).

9. Un appareil lithographique selon la revendication 8, où ledit joint de lentille (40) est flexible.

10. Un appareil lithographique selon soit la revendication 8, soit la revendication 9, où ledit joint de lentille (40) est de la colle.

11. Un appareil lithographique selon la revendication 1, où ledit élément d'étanchéité (12) comprend de plus un moyen d'étanchéité au gaz destiné à former un joint de gaz (16) entre ledit élément d'étanchéité (12) et la surface dudit substrat (W).

12. Un appareil lithographique selon la revendication 11, où ledit élément d'étanchéité (12) est monté sur un cadre de base.

13. Un appareil lithographique selon la revendication 12, où ledit élément d'étanchéité (12) est déplaçable par rapport audit cadre de base dans les directions Z, Rx et Ry et fixe dans toutes les autres directions.

14. Un procédé de fabrication de dispositif comprenant :
- fournir un substrat (W) ;
- fournir un faisceau de projection (PB) de rayonnement à l'aide d'un système d'illumination (IL) ;
- utiliser un moyen pour conformer selon un motif (MA) afin de conférer au faisceau de projection un motif dans sa coupe transversale ;
- fournir un liquide entre un élément final d'un système de projection (PL) utilisé dans ladite étape de projection et ledit substrat (W) en remplissant au moins partiellement un espace entre l'élément final et le substrat de liquide d'immersion ;
- fournir un élément d'étanchéité (12) s'étendant le long d'au moins une partie du pourtour dudit espace ; et
- projeter le faisceau de rayonnement à motif sur une portion cible du substrat (W),
- fournir un écoulement de gaz à partir d'un moyen servant à l'écoulement de gaz pour qu'il s'écoule dans l'espace au dessus dudit liquide d'immersion en direction du liquide d'immersion afin d'empêcher le gaz au dessus de et en contact avec ledit liquide d'immersion de s'échapper au-delà dudit moyen servant à l'écoulement de gaz, où ledit moyen servant à l'écoulement de gaz est arrangé de sorte que ledit écoulement de gaz soit entre ledit élément d'étanchéité (12) et ledit système de projection (PL).
